# EUROPÄISCHE PATENTSCHRIFT

(11) **EP 1 920 476 B1**
(45) Veröffentlichungstag und Bekanntmachung des Hinweises auf die Patenterteilung: **18.02.2009**
(21) Anmeldenummer: 06777875.3
(22) Anmeldetag: 21.07.2006
(51) Int. Cl.: H01L 41/053, H01L 41/04, F02M 51/06

(54) **ANORDNUNG MIT EINEM PIEZOAKTOR**
ARRANGEMENT WITH A PIEZO ACTUATOR
ENSEMBLE COMPRENANT UN ACTIONNEUR PIEZOELECTRIQUE

(30) Priorität: 24.08.2005 DE 102005039911
(43) Veröffentlichungstag der Anmeldung: 14.05.2008
(73) Patentinhaber: ROBERT BOSCH GMBH, 70442 Stuttgart (DE)
(72) Erfinder: HEINZ, Rudolf, 71272 Renningen (DE); KIENZLER, Dieter, 71229 Leonberg (DE); SCHAICH, Udo, 70378 Stuttgart (DE)
(86) Internationale Anmeldenummer: PCT/EP2006/064481
(87) Internationale Veröffentlichungsnummer: WO 2007/023046

(56) Entgegenhaltungen:
- DE-A1- 10 026 005
- DE-A1- 10 046 661
- DE-A1- 10 259 320
- DE-A1- 10 335 019
- DE-A1- 19 753 930

## Beschreibung

### Technisches Gebiet

Die Erfindung betrifft eine Anordnung mit einem Piezoaktor, beispielsweise als Piezoinjektor oder zur Betätigung eines mechanischen Bauteils wie ein Ventil oder dergleichen, mit einem elektrischen Anschluss für die Ansteuerung des Piezoelements über ein Fußteil des Piezoaktors nach den gattungsgemäßen Merkmalen des Hauptanspruchs.

### Stand der Technik

Es ist an sich bekannt, dass zum Aufbau des zuvor erwähnten Piezoaktors ein Piezoelement so eingesetzt werden kann, dass unter Ausnutzung des sogenannten Piezoeffekts eine Steuerung des Nadelhubes eines Ventils oder dergleichen vorgenommen werden kann. Das Piezoelement ist aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor aus der DE 100 26 005 A1 bekannt, der zur Ansteuerung der Düsennadel bei Piezoinjektoren zur Einspritzung von Kraftstoff in den Brennraum eines Verbrennungsmotors verwendet werden kann. Bei diesem Piezoaktor ist ein Piezoelement, wie erwähnt, als Stapel mehrerer elektrisch miteinander gekoppelter piezokeramischen Schichten aufgebaut, der unter Vorspannung zwischen zwei Anschlägen gehalten ist. Jede piezokeramische Schicht ist als Piezolage zwischen zwei Innenelektroden eingefasst über die von außen eine elektrische Spannung angelegt werden kann. Aufgrund dieser elektrischen Spannung führen die piezokeramischen Schichten dann jeweils kleine Hubbewegungen in Richtung des Potentialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei dem zuvor erwähnten Piezoaktor wird zur Heranführung der unterschiedlichen Potentiale eine wechselseitige seitliche Kontaktierung der Innenelektroden über äußere Elektroden vorgenommen, bei der leitende Flächen auf jeweils einer Seitenfläche des Piezoelements angebracht sind, die mit den jeweiligen Innenelektroden kontaktiert sind. Dagegen ist aus der DE 103 35 019 A1 ein Piezoaktor bekannt, bei dem die Kontaktierung der Innenelektroden mit Kontaktelementen erfolgt, die jeweils in einer inneren Ausnehmung des Piezoelements liegen.

Außerdem ist auch in der EP 1 174 615 A3 ein Piezoaktor beschrieben, bei dem ein Piezoelement als Aktormodul für die direkte Nadelhubsteuerung eines Einspritzinjektors für einen Verbrennungsmotor vorhanden ist. Zwischen dem Piezoelement als Aktor und der Nadel sitzt lediglich ein Koppler mit einer hydraulischen Übersetzung zum Dehnungsausgleich. Mit einer Aktivierung des Piezoelements wird hierbei die unter Vorspannung zum Verschluss der Einspritzdüse gehaltene Nadel von der Düsenöffnung wegbewegt, da die Nadel direkt übersetzt der Bewegung des Aktors folgt.

Beim eingangs erwähnten Stand der Technik DE 100 26 005 wird der elektrische Anschluss des Piezoelements an eine externe Spannungsquelle durch eine Verlängerung der äußeren Elektroden durch ein Fußteil des Piezoaktors hindurch vorgenommen. Diese Verlängerung kann auch weiter bis zu einem Stecker geführt werden, so dass diese somit in einem mechanisch unkritischen Bereich kontaktiert werden. Die Verlängerungen können dabei elektrisch isoliert durch den Aktorfuß, z.B. aus Stahl, geführt werden, an dem das Piezoelement anliegt oder befestigt ist. Weiterhin ist es aus diesem Stand der Technik bekannt, dass die Verlängerungen zur Fixierung und zur Zugentlastung der Außenelektroden in einer Vergussmasse gehalten sind, welche in eine Ausnehmung des Aktorfußes, ggf. von einem Formteil aus Stahl oder Polymer umgeben, eingebracht sind.

Bei den zuvor beschriebenen Piezoaktoren ist zu beachten, dass die elektrischen Anbindungen im Herstellungsprozess einfach aber im Betrieb sicher erfolgen sollen, wobei zusätzlich zur elektrischen Isolierung auch bei vielen Anwendungen mit einer Ventilfunktion eine ausreichende Abdichtung gegenüber Flüssigkeiten gewährleistet sein muss. Insbesondere bei einer Anwendung der Piezoaktoren als Einspritzinjektoren für Kraftstoff in sogenannten Common-Rail-Systemen (CR) ist bei den verwendeten hohen Drücken des Kraftstoffs eine sichere Bauweise erforderlich.

### Offenbarung der Erfindung

Die Erfindung geht von einem eingangs beschriebenen Piezoaktor aus, der einen Mehrschichtaufbau von Piezolagen aufweist, die als Piezoelement in einem Haltekörper gehalten sind, wobei am Piezoelement eine wechselseitige Kontaktierung von Innenelektroden mit Kontaktelementen vorhanden ist. Weiterhin ist ein Aktorfuß zwischen dem Piezoelement und der Wand einer inneren Ausnehmung des Haltekörpers vorhanden, durch den elektrische Leitungen zu den Kontaktelementen geführt sind. Erfindungsgemäß ist der Aktorfuß in vorteilhafter Weise aus einem Anbindeteil am Haltekörper und einem Keramikteil in Richtung des Piezoelements gebildet. Ein solche Anordnung ist beispielsweise vorteilhaft zur Steuerung des Hubs einer Nadel für die Kraftstoffeinspritzung in einem Kraftfahrzeug einsetzbar und zwar sowohl mit einer einstufigen als auch mit einer zweistufigen Übersetzung.

Mit der Erfindung ist es in vorteilhafter Weise erreicht, dass zum Beispiel mit der für sich gesehen bekannten Glaseinschmelzungen der Leitungen im Keramikteil eine sehr kompakt bauende elektrisch isolierende Hochdruckabdichtung (max. 2500 bar) in einem Hochdruckventil als Injektor der eingangs beschriebenen Art mit einem Piezoelement geschaffen werden kann, welche auf kleinstem Raum das Anbinden des Piezoelements an einen Haltekörper in unterschiedlichsten Varianten ermöglicht und dabei die elektrischen Leiter des Piezoelements gegenüber der äußeren kundenspezifischen Steckverbindung des Injektors hochdruckdicht abdichtet.

Dabei ist es möglich, dass eine beliebige Anzahl von elektrischen Leitern, in der Regel jedoch zwei Leitungen, bzw. die dafür notwendigen Durchführungen, in der hochdruckdichten Keramik parallel sowie unter jedem beliebigen Winkel, auch zueinander, angeordnet sein können. Das Keramikteil ermöglicht dabei das Führen von unisolierten elektrischen Leitern, welche direkt in der Keramik hochdruckdicht eingelötet, glasgeklebt oder glaseingeschmolzen werden können. Durch die elektrisch isolierende Eigenschaft der Keramik sind Kriechströme zwischen den Leitern und den metallischen Bauteilen des Injektors ausgeschlossen.

Der erfindungemäße Aktorfuß kann dabei mit dem Haltekörper oder auch mit anderen beliebigen Wechselteilen über das Anbindeteil mittels Löten, Schweißen oder Verschraubungen direkt verbunden werden. Dabei können das Anbindeteil und das Keramikteil untereinander mittels Aktivlöten oder Glasklebung hochdruckdicht miteinander verbunden werden. Hierbei ist vorzugsweise das Anbindeteil aus Metall und die Leitungen sind durch eine Isolierung im Anbindeteil geführt. Das Anbindeteil kann jedoch auch aus einem beschichteten oder je nach Bedarf nichtmetallischen Material bestehen.

Die Form und das Material des Anbindeteils sind je nach Anwendung frei wählbar, sie müssen lediglich hochdruckdicht mit dem Keramikteil verbindbar sein. Die Konturen der Verbindungsstellen zwischen dem Keramikteil und dem Anbindeteil können ebenfalls je nach Material, Festigkeitsanforderungen oder geforderter Positionsgenauigkeit frei gestaltet werden, z.B. mit Plan- oder Führungsnuten sowie mit einem entsprechendem äußeren Passdurchmesser.

Zur elektrischen Isolation der Leiter im Anbindeteil können zum Beispiel Keramik- oder Kunststoffbuchsen etc. eingepresst werden. Ein Ausspritzen mit Kunststoff oder einem weiteren Keramikteil ist ebenfalls möglich sowie ein Eintauchen einer isolierenden Leitungsummantelung in die Aussparungen zur Aufnahme der Leiter wie deren Umspritzung mit Kunststoff.

Mit der Erfindung ist auf einfache Weise erreicht, dass neben der Funktion einer Hochdruckabdichtung mit einer üblichen Glaseinschmelzung von abzudichtenden Bauteilen zusätzlich die Aufgabe des sonst verwendeten Aktorfußes als steifes Widerlager des Piezoelements im Piezoaktor erfüllt wird. Somit können zwei Funktionen in einem Bauteil realisiert werden und der benötigte Bauraum ist daher reduziert. Die Kombination aus dem Keramikteil und dem durch Löten bzw. Kleben aufgebrachten Anbindeteil ermöglicht eine kompakte Ausführung unter Verwendung der Vorteile der jeweiligen Materialeigenschaften.

Die Keramik eines Sinterkörpers als Keramikteil ist in ihrer molekularen Struktur an sich hochdruckdicht und nimmt die elektrischen Kontakte isoliert auf, die z.B. mittels Glas eingeschmolzen, eingeklebt oder über Aktivlöten unter Schutzgas direkt in der Keramik hochdruckdicht eingebracht werden können. Beim Glaseinschmelzen unterstützt der in der Keramik beigemischte Glassanteil die Festigkeit und Dichtheit der Verbindung zwischen den Glasmolekülen des Glases und der Keramik. Der Glasmantel muss deshalb im Vergleich zu üblichen Glaseinschmelzungen nicht so stark ausgebildet sein. Beim Aktivlöten der Leitungen übernimmt die Keramik vor allem die elektrische Isolation der Leitungen zueinander, sowie die elektrische Isolation nach außen zum Injektorgehäuse bzw. dem Verbrennungsmotor.

Bei der Erfindung kann gegenüber den üblichen Hochdruckglaseinschmelzungen auf die äußeren Metallstützringe verzichtet werden, welche aus Festigkeitsgründen den max. Durchmesserfaktor von 1,4 des max. Glasdurchmesser benötigen und somit den Bauraumbedarf stark erhöhen. Mindestbaulängen der Hersteller müssen dabei ebenfalls konstruktiv am Injektor nicht mehr berücksichtigt werden. Dieser Bauraum steht häufig bei den modernen Auslegungen nicht zur Verfügung, vor allem wenn mehrere Leitungen in kleinen Bauräumen nebeneinander geführt und abgedichtet werden müssen. Gleichzeitig müssen bei den bekannten Anordnungen häufig auch Mindestabstände bezüglich elektrischer Kriechströme eingehalten werden, so dass weitere Einschränkungen bei der Gestaltung der Bauteile gegeben sind, zum Beispiel wenn Winkelanordnungen der Glaseinschmelzungen vorgesehen sind.

Mit den erfindungemäßen Ausführungsformen können die zuvor genannten Einschränkungen aufgehoben werden, da die Bauteile flexibler gestaltet werden können, z.B. bei der Führung der elektrischen Leitungen und der den Anforderungen angepassten Gestaltung des Anbindeteils. Üblicherweise ist die Auswahl der Materialien beim Glaseinschmelzprozess in Stahl sehr eingeschränkt, da die Festigkeit der Stähle durch die hohen Prozesstemperaturen von über 1000°C stark abnimmt. Durch das Löten, z.B. Aktivlöten oder Kleben, oder beispielsweise mit einem Glaskleber können bei der Erfindung verschiedene Materialpaarungen erzeugt und miteinander verbunden werden, ohne dass die in der Regel metallischen Anbindeteile durch die hohen Sintertemperaturen beim Glaseinschmelzprozess ihre Festigkeit verlieren.

### Kurze Beschreibung der Zeichnungen

Ausführungsbeispiele der erfindungsgemäßen Anodnung werden anhand der Zeichnungen erläutert. Es zeigen:
Figur 1 einen Längsschnitt durch einen herkömmlichen einstufigen Piezoaktor zur Steuerung einer Düsennadel in Kraftstoffeinspritzsystemen zur Erläuterung des prinzipiellen Aufbaus,
Figur 2 einen Teilschnitt durch einen Aktorfuß mit einer elektrischen Kontaktierung von Außenelektroden des Piezoelements bei einem Piezoaktor nach der Figur 1 als Stand der Technik,
Figur 3a und 3b einen Teilschnitt und einen Querschnitt durch eine erfindungsgemäße Ausführung der Durchführung der elektrischen Kontaktierung durch den Aktorfuß an äußere Kontaktelemente für die Innenelektroden des Piezoelements,
Figur 4a und 4b einen Teilschnitt und einen Querschnitt durch eine erfindungsgemäße Ausführung der Durchführung der elektrischen Kontaktierung durch den Aktorfuß in Abwandlung zu den Figuren 3a und 3b mit konischem Bohrungen,
Figur 5a und 5b einen Teilschnitt und einen Querschnitt durch eine zweite erfindungsgemäße Ausführung der Durchführung der elektrischen Kontaktierung durch den Aktorfuß an innenliegende Kontaktelemente mit abgewinkelter Leitungsführung und
Figur 6a und 6b einen Teilschnitt und einen Querschnitt durch eine zweite erfindungsgemäße Ausführung der Durchführung der elektrischen Kontaktierung durch den Aktorfuß an innenliegende Kontaktelemente mit gerader Leitungsführung.

### Ausführungsfom(en) der Erfindung

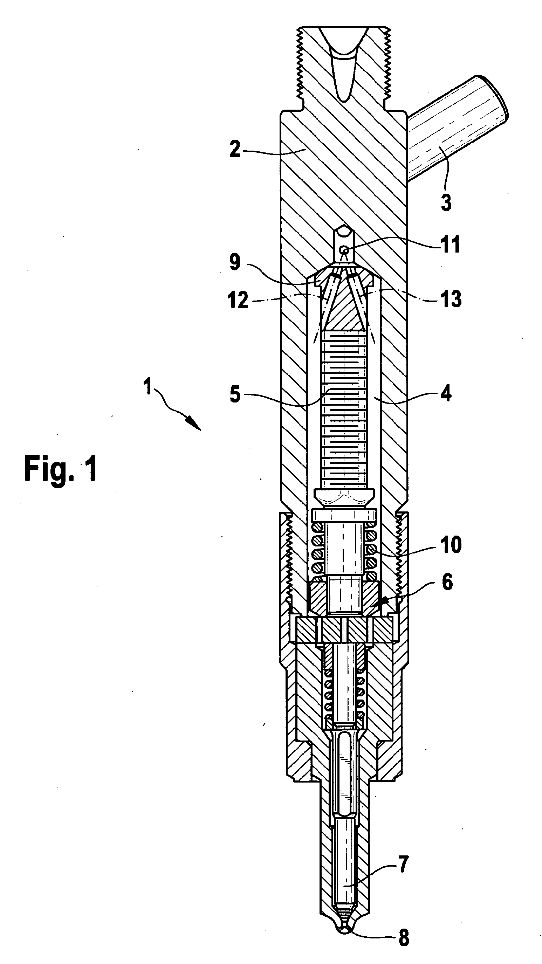

In Figur 1 ist ein prinzipieller Aufbau einer Anordnung mit einem einstufigen Piezoaktors 1 gezeigt, die beispielsweise zur Nadelhubsteuerung im Einspritzsystem für Kraftstoff bei einem Verbrennungsmotor eingesetzt werden kann. Im oberen Teil ist ein Haltekörper 2 vorhanden, der in seinen geometrischen Abmessungen im wesentlichen an den spezifischen Einsatzort angepasst werden kann. Es ist eine Steckerteil 3 zu erkennen, durch das mit einer ebenfalls spezifisch an den Anwendungsfall angepassten Steckerausführung die elektrische Spannung für die Steuerung eines Piezoelements 5 angeschlossen werden kann. Die Führung der elektrischen Leitung und eine eventuelle Zuführung des mit dem Piezoaktor 1 zu steuernden Kraftstoffs im Haltekörper 2 ist hierbei nicht zu erkennen und für die Funktion der Erfindung auch nicht wesentlich.

In einem Innenraum 4 des Piezoaktors 1 ist das Piezoelement 5 angeordnet, das bei einer Betätigung über eine sich hier senkrecht unterhalb befindliche mechanische Anordnung mit einem Koppler 6 auf eine Düsennadel 7 derart wirkt, dass hier eine Freigabe einer Düsenöffnung 8 erfolgen kann. Ein im Inneren des Piezoaktors 1 durch den Innenraum 4 geführter Kraftstoff kann somit in den Brennraum eines hier nicht dargestellten Verbrennungsmotors injiziert werden.

Das Piezoelement 5 liegt nach der Figur 1 über einen Aktorfuß 9 oben an einem balligen Dichtsitz im Innenraum 4 an, wobei das Piezoelement 5 zur bewirkung eines guten Dichtsitzes mit einer Feder 10 angedrückt wird. Insbesondere bei den eingangs erwähnten Common-Rail (CR)-Systemen ist hier eine Hochdruckabdichtung zu einem elektrischen Anschlussraum 11 notwendig, durch den zwei hier schematisch angedeutete elektrische Leitungen 12 und 13 an das Piezoelement 5 geführt sind.

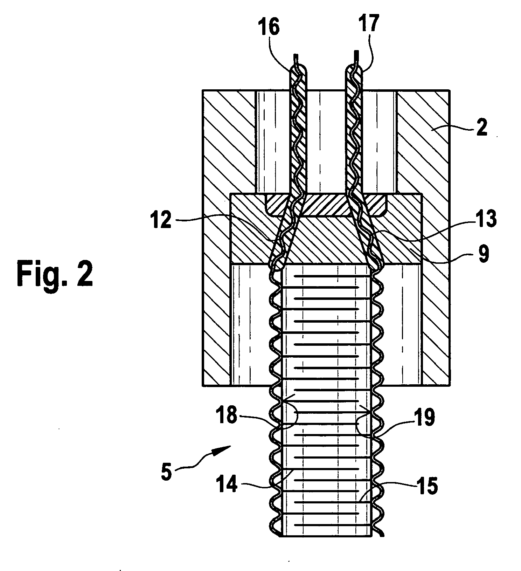

Aus Figur 2 ist eine solche bereits aus dem Stand der Technik DE 100 26 005 A1 bekannte Anordnung der in einer Vergussmasse liegenden elektrischen Leitungen 12 und 13 im Aktorfuß 9 zu entnehmen. Hier sind in an sich bekannter Weise beim Piezoelement 5 die Piezolagen übereinander gestapelt, die aus keramischen Piezofolien mit einer geeigneten Kristallstruktur so aufgebaut sind, so dass unter Ausnutzung des sogenannten Piezoeffekts in der eingangs beschriebenen Art und Weise bei Anlage einer äußeren elektrischen Spannung an hier nur beispielhaft mit Bezugszeichen versehene Innenelektroden 14 und 15 eine mechanische Reaktion des Piezoelements 5 in zur Richtung des Stapelaufbaus erfolgt. Die Zuführung der unterschiedlichen Pole der elektrischen Spannung erfolgt hier jeweils von einer Seite über äußere Kontaktelemente 16 und 17, die jeweils über äußere Kontaktflächen 18 und 19 wechselseitig an die Innenelektroden 14 und 15 der jeweiligen Piezolage geführt sind.

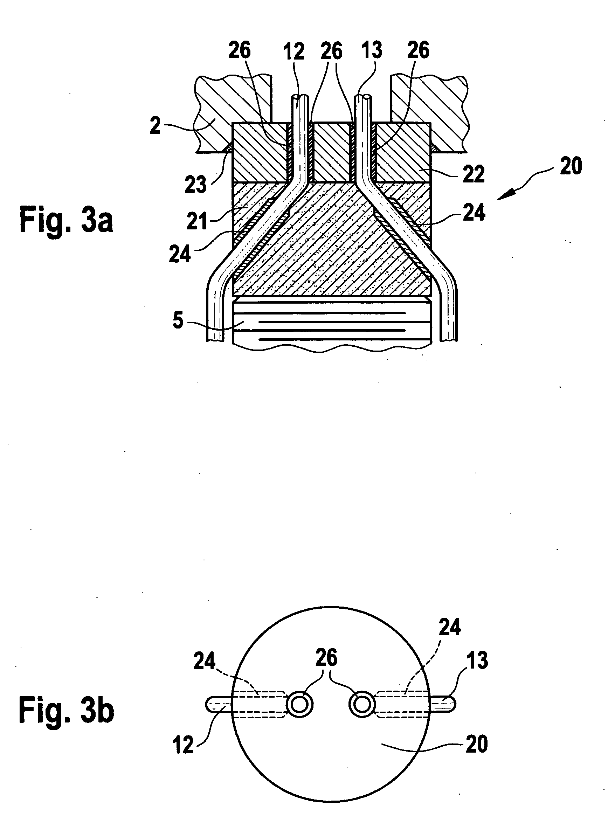

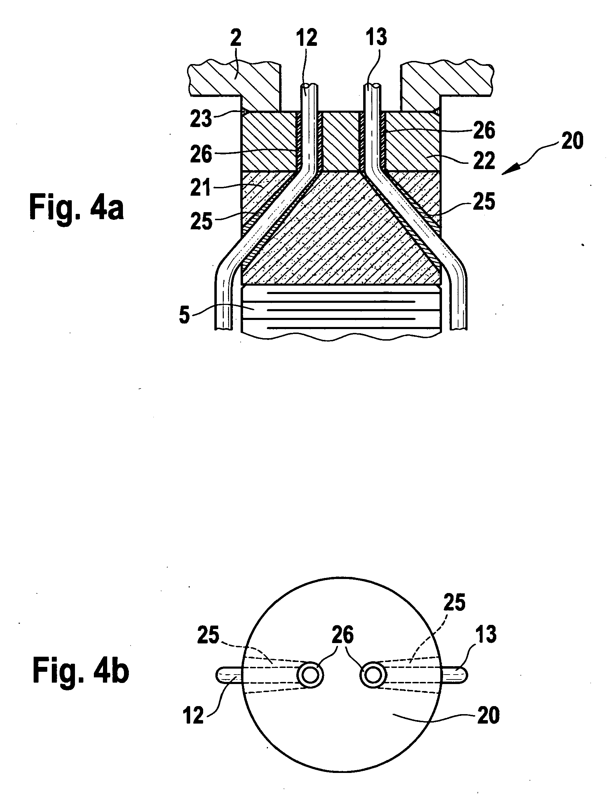

Figur 3a und 3b zeigt ein Ausführungsbeispiel einer Führung der Leitungen 12 und 13 für die elektrischen Kontaktierungen im Piezoaktor 1 durch einen erfindungsgemäßen Aktorfuß 20 und Figur 4 zeigt eine Draufsicht. Der Aktorfuß 20 besteht aus einem elektrisch isolierenden Keramikteil 21 und einem Anbindeteil 22 aus Metall, zum Beispiel Stahl oder NE-Metall, wobei das Anbindeteil 22 beispielsweise über Lötstellen 23 an den Haltekörper 2 angefügt werden kann und zwischen dem Anbindeteil 22 und dem Keramikteil 21 eine Verbindung über Aktivlöten oder mittels einer Glasklebung vorgenommen werden kann. Das Keramikteil 21 liegt auf dem Piezoelement 5 auf.

In den Figuren 3a und 3b liegen die Leitungen 12 und 13 jeweils in einer Aussparung 24, die beim Aktivlöten mit Lot gefüllt werden kann und die Leitung 12 und 13 nach den Figuren 4a und 4b befinden sich jeweils in einer nach oben konisch verlaufenden Bohrung 25 in der eine Glaseinschmelzung vorgenommen werden kann. Bei der Führung der Leitungen 12 und 13 durch das Anbindeteil 22 sind hier Isolierungen 26 vorgesehen. Die Verbindung mit den äußeren Kontaktierungen des Piezoelements 5 erfolgt in der gleichen Weise wie beim Stand der Technik nach der Figur 2.

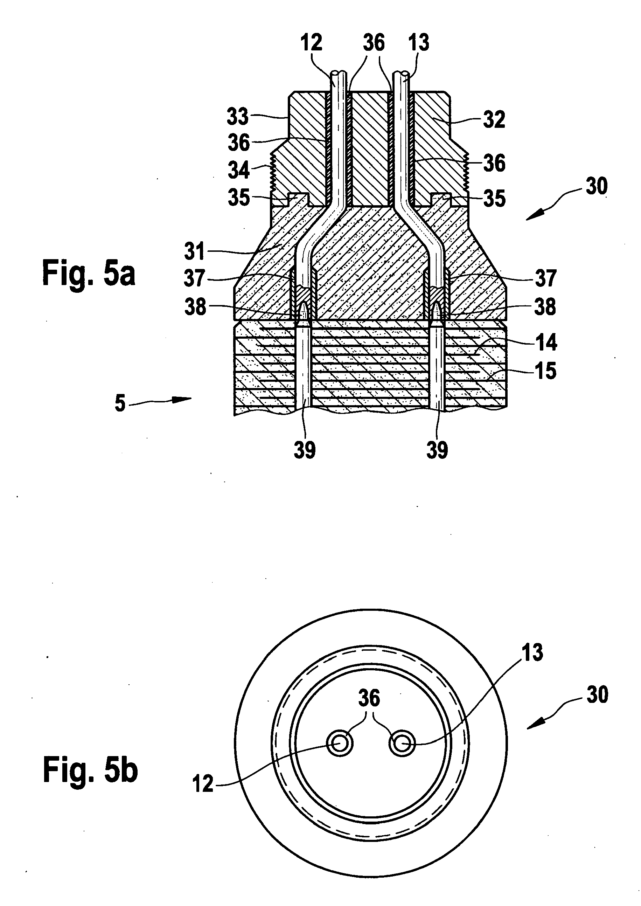

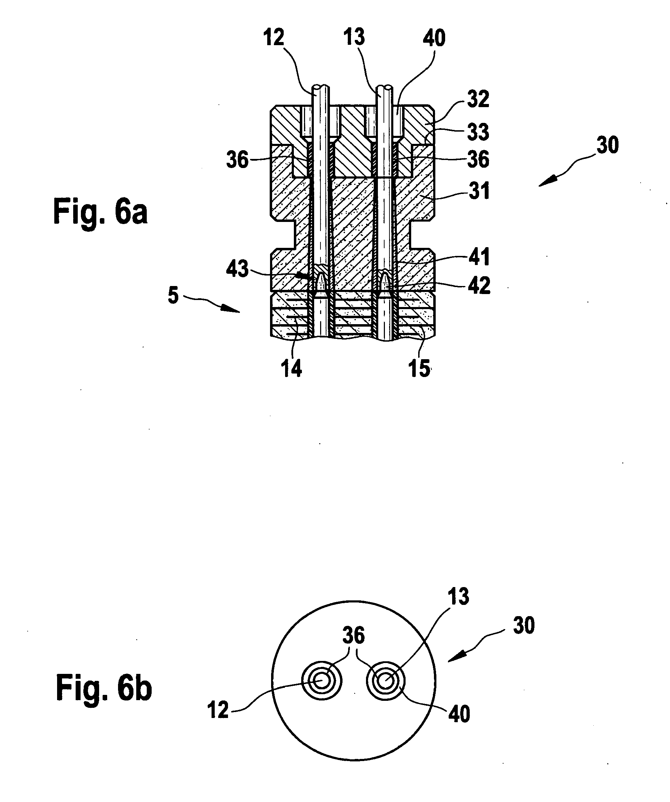

Figur 5a und 6a zeigt jeweils ein weiteres Ausführungsbeispiel einer Führung der Leitungen 12 und 13 für die elektrischen Kontaktierungen im Piezoaktor 1 durch einen erfindungsgemäßen Aktorfuß 30 und Figur 5b und 6b zeigt jeweils eine Draufsicht. Im Unterschied zum Ausführungsbeispiel nach den Figuren 3a,4b und 4a,4b wird hier eine innenliegende Kontaktierung von Innenelektroden im Piezoelement 5 in zwei Varianten vorgenommen. Der Aktorfuß 30 besteht auch hier aus einem elektrisch isolierenden Keramikteil 31 und einem Anbindeteil 32 aus Metall, zum Beispiel Stahl oder NE-Metall, die wie bei dem zuvor beschriebenen Ausführungsbeispiel miteinander verbunden werden können.

In der gezeigten Variante nach der Figur 5a.5b ist das Anbindeteil 32 mittels Pass- oder Führungszapfen 33 und eines Verschraubungsgewindes 34 an den Haltekörper 2 anbringbar. In der Variante nach der Figur 6a,6b sind noch Aussparungen 35 für eine Indexierung, Schlüsselflächen oder Konturen für zusätzliche Aktorisolierungen vorhanden.

Die Leitung 12 und 13 nach den Figuren 5a und 5b sind auch hier durch eine Isolierung 36 im Anbindeteil 32 und dann im Keramikteil 31 leicht angewinkelt geführt. Mittels einer Lötverbindung 37 sind die Leitungen 12 und 13hier im Keramikteil 31 gehalten und können dann jeweils über eine Steckverbindung 38 mit den Kontaktelementen 39 für die innere Kontaktierung der Innenelektroden 14 und 15 verbunden werden.

Die Leitungen 12 und 13 nach den Figuren 6a,6b sind hier gerade durch das Anbindeteil 32 und das Keramikteil 31 geführt, wobei im Unterschied zur Ausführung im linken Teil noch oben im Anbindeteil 32 ein Freigang 40 für eine Direktkontaktierung angebracht ist und die Halterung im Keramikteil 31 ist hier mittels einer Glaseinschmelzung 41 realisiert. Die Verbindung zu einem Kontaktelement 42 zur inneren Kontaktierung der Innenelektroden 14 und 15 wird hier über eine Steckverbindung 43 vorgenommen.

### Gewerbliche Anwendbarkeit

Die erfindungsgemäße Anordnung ist beispielsweise vorteilhaft zur Steuerung des Hubs einer Nadel für die Kraftstoffeinspritzung in einem Kraftfahrzeug gewerblich einsetzbar.

## Patentansprüche

1. Anordnung mit einem Piezoaktor, mit
- einem Mehrschichtaufbau von Piezolagen des Piezoaktors, die als Piezoelement (5) in einem Haltekörper (2) gehalten sind, wobei am Piezoelement (5) eine wechselseitige Kontaktierung von Innenelektroden (14,15) mit Kontaktelementen (16,17; 39,42) vorhanden ist und mit
- einem Aktorfuß (9;21,22;31,32) zwischen dem Piezoelement (5) und der Wand einer inneren Ausnehmung (4) des Haltekörpers (2), durch den elektrische Leitungen (12,13) zu den Kontaktelementen (16,17; 39,42) geführt sind, **dadurch gekennzeichnet, dass**
- der Aktorfuß aus einem Anbindeteil (22;32) am Haltekörper (2) und einem Keramikteil (21;31) in Richtung des Piezoelements (5) gebildet ist.

2. Anordnung nach Anspruch 1, **dadurch gekennzeichnet, dass**
- das Anbindeteil (22;32) und das Keramikteil (21;31) mittels einer Aktivlötung oder Glasklebung miteinander verbunden sind.

3. Anordnung nach Anspruch 1 oder 2, **dadurch gekennzeichnet, dass**
- das Anbindeteil (22;32) und der Haltekörper (2) mittels Löten, Schweißen oder Verschraubungen miteinander verbunden sind.

4. Anordnung nach einem der vorhergehenden Ansprüche, **dadurch gekennzeichnet, dass**
- das Anbindeteil (22;32) aus Metall ist und die Leitungen (12,13) durch eine Isolierung (26;36) im Anbindeteil (22;32) geführt sind.

5. Anordnung nach einem der vorhergehenden Ansprüche, **dadurch gekennzeichnet, dass**
- die Leitungen (12,13) mittels einer Aktivlötung in Erweiterungen (24) der Durchführungen im Keramikteil (21;31) gehalten sind.

6. Anordnung nach einem der Ansprüche 1 bis 4, **dadurch gekennzeichnet, dass**
- die Leitungen (12,13) mittels einer Glaseinschmelzung in konisch erweiterten Durchführungen (25) im Keramikteil (21 ;31) gehalten sind.

7. Anordnung nach einem der vorhergehenden Ansprüche, **dadurch gekennzeichnet, dass**
- die Verbindung der Leitungen (12,13) und der Kontaktelemente (39,42) jeweils mittels eines Steckkontakts (43) vorgenommen ist.

8. Anordnung nach einem der vorhergehenden Ansprüche, **dadurch gekennzeichnet, dass**
- die Kontaktierung der Innenelektroden (14,15) über äußere Kontaktelemente auf Kontaktflächen (18,19) des Piezoelements (5) erfolgt.

9. Anordnung nach einem der Ansprüche 1 bis 7, **dadurch gekennzeichnet, dass**
- die Kontaktierung der Innenelektroden (14,15) über innenliegende Kontaktelemente (39,42) in inneren Bohrungen des Piezoelements (5) erfolgt.

10. Anordnung nach einem der vorhergehenden Ansprüche, **dadurch gekennzeichnet, dass**
- die gesamte Anordnung zur direkten Steuerung des Hubs einer Nadel (7) für die Kraftstoffeinspritzung in einem Kraftfahrzeug einsetzbar ist.

## Claims

1. Arrangement with a piezo actuator, comprising
- a multilayer structure of piezo layers of the piezo actuator which are held in the form of a piezo element (5) in a holding body (2), wherein alternating contacting of inner electrodes (14, 15) with contact elements (16, 17; 39, 42) takes place on the piezo element (5), and comprising
- an actuator foot (9; 21, 22; 31, 32) between the piezo element (5) and the wall of an inner recess (4) of the holding body (2), through which actuator foot electric lines (12, 13) are led to the contact elements (16, 17; 39, 42), **characterized in that**
- the actuator foot is formed by a linking part (22; 32) on the holding body (2) and a ceramic part (21; 31) in the direction of the piezo element (5).

2. Arrangement according to Claim 1, **characterized in that**
- the linking part (22; 32) and the ceramic part (21; 31) are connected to one another by means of an active solder or glass bond.

3. Arrangement according to Claim 1 or 2, **characterized in that**
- the linking part (22; 32) and the holding body (2) are connected to one another by means of soldering, welding or screw connections.

4. Arrangement according to one of the preceding claims, **characterized in that**
- the linking part (22; 32) is composed of metal and the lines (12, 13) are led through an insulating means (26; 36) in the linking part (22; 32).

5. Arrangement according to one of the preceding claims, **characterized in that**
- an active solder is used to hold the lines (12, 13) in widened portions (24) of the leadthroughs in the ceramic part (21; 31).

6. Arrangement according to one of Claims 1 to 4, **characterized in that**
- a fused glass seal is used to hold the lines (12, 13) in conically widened leadthroughs (25) in the ceramic part (21; 31).

7. Arrangement according to one of the preceding claims, **characterized in that**
- the lines (12, 13) and the contact elements (39, 42) are connected in each case by means of a plug-in contact (43).

8. Arrangement according to one of the preceding claims, **characterized in that**
- the inner electrodes (14, 15) are contacted by means of outer contact elements on contact surfaces (18, 19) of the piezo element (5).

9. Arrangement according to one of Claims 1 to 7, **characterized in that**
- the inner electrodes (14, 15) are contacted by means of inner contact elements (39, 42) in inner bores of the piezo element (5).

10. Arrangement according to one of the preceding claims, **characterized in that**
- the entire arrangement can be used for directly controlling the stroke of a needle (7) for the injection of fuel in a motor vehicle.

## Revendications

1. Système à piézo-actionneur, qui présenté :
une structure multicouche de couches piézo-électriques du piézo-actionneur qui sont maintenues comme élément piézo-électrique (5) dans un corps de maintien (2), l'élément piézo-électrique (5) présentant des contacts alternés entre les électrodes intérieures (14, 15) et des éléments de contact (16, 17; 39, 42) et un pied d'actionneur (9; 21, 22; 31, 32) situé entre l'élément piézo-électrique (5) et la paroi d'une des couches intérieures (4) du corps de maintien (2), et par lequel des conducteurs électriques (12, 13) sont amenés aux éléments de contact (16, 17; 39, 42) **caractérisé en ce que**
le pied d'actionneur est formé d'une pièce de liaison (22; 32) prévue sur le corps de maintien (2) et d'une pièce en céramique (21; 31) dirigée vers l'élément piézo-électrique (5).

2. Système selon la revendication 1, **caractérisé en ce que** la pièce de liaison (22; 32) et la pièce en céramique (21; 31) sont reliées l'une à l'autre par brasage actif ou liaison au verre.

3. Système selon les revendications 1 ou 2, **caractérisé en ce que** la pièce de liaison (22; 32) et le corps de maintien (2) sont reliés l'un à l'autre par brasage, soudage ou vissage.

4. Système selon l'une des revendications précédentes, **caractérisé en ce que** la pièce de liaison (22; 32) est réalisée en métal et **en ce que** les conducteurs (12, 13) sont passés à travers une isolation (26; 36) prévue dans la pièce de liaison (22; 32).

5. Système selon l'une des revendications précédentes, **caractérisé en ce que** les conducteurs (12, 13) sont maintenus au moyen d'un brasage actif dans des évasements (24) des passages prévus dans la pièce en céramique (21; 31).

6. Système selon l'une des revendications 1 à 4, **caractérisé en ce que** les conducteurs (12, 13) sont maintenus au moyen d'une fusion au verre dans des passages évasés (25) coniquement qui sont ménagés dans la pièce en céramique (21; 31).

7. Système selon l'une des revendications précédentes, **caractérisé en ce que** la liaison entre les conducteurs (12, 13) et les éléments de contact (39, 42) est réalisée chaque fois par un contact enfichable (43).

8. Système selon l'une des revendications précédentes, **caractérisé en ce que** la mise en contact des électrodes intérieures (14, 15) s'effectue par l'intermédiaire d'éléments extérieurs de contact placés sur les surfaces de contact (18, 19) de l'élément piézo-électrique (5).

9. Système selon l'une des revendications 1 à 7, **caractérisé en ce que** la mise en contact des électrodes intérieures (14, 15) s'effectue par des éléments intérieurs de contact (39, 42) prévus dans des alésages intérieurs de l'élément piézo-électrique (5).

10. Système selon l'une des revendications précédentes, **caractérisé en ce que** l'ensemble du système peut être utilisé pour commander directement la course d'un pointeau (7) d'injection de carburant dans un véhicule automobile.
